# DEMANDE DE BREVET EUROPEEN

(11) **EP 4 120 489 A1**
(43) Date de publication de la demande: **18.01.2023**
(21) Numéro de dépôt: 22185168.6
(22) Date de dépôt: 15.07.2022
(51) Int. Cl.: H02B 1/28, H02B 1/30, H02B 1/56

(54) **PAROI POUR UNE ARMOIRE ÉLECTRIQUE, ARMOIRE ÉLECTRIQUE COMPORTANT UNE TELLE PAROI**

(30) Priorité: 16.07.2021 FR 2107703
(71) Demandeur: Schneider Electric Industries SAS, 92500 Rueil-Malmaison (FR)
(72) Inventeur: NIEMBRO, Alejandro, 38000 GRENOBLE (FR); BERTHOUD, Yoann, 38000 GRENOBLE (FR); DREINA, Emmanuel, 38240 MEYLAN (FR)
(74) Mandataire: Lavoix

(57) **Abrégé**

Cette paroi de protection métallique (8) pour une armoire électrique est configurée pour délimiter au moins en partie un logement dans l'armoire électrique, ledit logement étant destiné à recevoir un appareil électrique capable de communiquer par radio.

La paroi de protection comporte un corps (10) plat et une pluralité d'ouvertures (12) traversantes formées dans le corps.

Les ouvertures sont formées par répétition périodique d'un même motif dans le plan du corps, le motif comprenant une ou plusieurs fentes ménagées dans le corps avec une forme géométrique spécifique et en ce que laquelle la pluralité d'ouvertures formée par répétition du motif présente une symétrie de rotation d'angle égal ou sensiblement égal à 120°.

## Description

La présente invention concerne le domaine des armoires électriques.

Plus précisément, l'invention concerne une paroi pour une armoire électrique, et une armoire électrique comportant une telle paroi.

De façon connue, dans les installations de distribution d'électricité, il est courant de loger des appareils électriques, tels que des appareils de commutation, dans des armoires électriques qui comportent une armature et des parois de séparation interne, généralement réalisées dans un matériau métallique.

Les parois permettent de séparer les appareils les uns des autres et ainsi présente une fonction de sécurité, par exemple pour protéger les utilisateurs et empêcher un accès accidentel à un appareil pendant qu'un utilisateur est en train d'intervenir sur un autre appareil.

L'utilisation de matière métallique pour former les parois permet d'obtenir une bonne tenue mécanique tout en étant relativement aisées à fabriquer industriellement.

Un problème se pose cependant avec les générations contemporaines d'appareils électriques, qui incorporent de plus en plus souvent des fonctionnalités de communication sans fil. Lorsque de tels appareils communicants sont logés dans des armoires électriques, les parois en métal entravent, voire empêchent, les ondes radio de se propager à l'extérieur de l'armoire électrique. Les appareils ne peuvent donc pas fonctionner correctement.

Il a été proposé d'utiliser des parois métalliques sélectives en fréquence (Frequency Selective Surfaces en anglais) afin de laisser passer les ondes radio, au moins en partie.

Pour y parvenir, les ouvertures de ventilation de la paroi sont dimensionnées de manière à assurer une bonne transmission des ondes radio pour certaines plages de fréquence. Toutefois, ces solutions connues ne sont généralement pas compatibles avec les exigences normatives en termes d'étanchéité et de résistance aux chocs.

Par exemple, la demande de brevet CN 110248529 A décrit une paroi qui comporte une ouverture centrale permettant de laisser passer des ondes radio, mais qui ne permet cependant pas d'obtenir une étanchéité satisfaisante, ni d'assurer une bonne protection contre les chocs ou contre l'intrusion non désirée de corps étrangers. De plus, la paroi est formée en plusieurs parties (substrat, éléments additionnels déposés sur le substrat), ce qui complique la fabrication de la paroi.

C'est à ces inconvénients qu'entend plus particulièrement remédier l'invention en proposant une paroi pour une armoire électrique, et une armoire électrique correspondante, qui présentent une bonne étanchéité aux corps étrangers et une bonne résistance aux chocs tout en permettant le passage d'ondes radiofréquence.

A cet effet, un aspect de l'invention concerne une paroi de protection métallique pour une armoire électrique, la paroi de protection étant configurée pour délimiter au moins en partie un logement dans l'armoire électrique, ledit logement étant destiné à recevoir un appareil électrique capable de communiquer par radio, dans laquelle la paroi de protection comporte un corps plat et une pluralité d'ouvertures traversantes formées dans le corps, en ce que les ouvertures sont formées par répétition périodique d'un même motif dans le plan du corps et dans laquelle la pluralité d'ouvertures formée par répétition du motif présente une symétrie de rotation d'angle égal ou sensiblement égal à 120°.

Grâce à l'invention, le dimensionnement du motif et la façon dont ce motif est répété périodiquement dans le plan du corps permettent d'obtenir une transmission satisfaisante des ondes radio fréquence au travers de la paroi, au moins pour la gamme de fréquences d'intérêt, et pour une plage suffisamment élevée d'angles d'incidence des ondes radio.

Les ouvertures sont suffisamment grandes pour permettre un passage suffisant de l'air et donc assurer une bonne ventilation, mais restent suffisamment petites pour ne pas nuire aux propriétés mécaniques de la paroi, notamment en ce qui concerne la résistance aux chocs, ou à la faculté d'empêcher des corps étrangers de pénétrer au travers de la paroi.

Selon des aspects avantageux mais non obligatoires, une telle paroi peut incorporer une ou plusieurs des caractéristiques suivantes, prises isolément ou suivant toute combinaison techniquement admissible :
- La paroi de protection présente un niveau d'étanchéité supérieur ou égal à l'indice de protection IP2X défini par la norme EN 60529.
- La paroi de protection présente un niveau de résistance aux chocs supérieur ou égal à l'indice de protection IK02 défini par la norme EN 62262.
- La paroi de protection permet la transmission des ondes radio pour les fréquences comprises dans la bande de fréquences ISM à 2,4 GHz.
- Le motif comporte trois bras équidistants s'étendant radialement depuis une zone centrale, les bras étant séparés deux à deux par un angle de 120°.
- Le motif comporte trois fentes ménagées dans le corps, chaque fente présentant une forme recourbée et définissant une partie de deux bras consécutifs, chacune des extrémités terminales de chaque fente étant alignée avec une extrémité terminale d'une autre fente.
- Les trois bras équidistants du motif s'étendant radialement depuis une zone centrale sont joints entre eux par leurs extrémités dans la zone centrale.
- Le motif comporte une fente à trois bras, l'extrémité distale de chaque bras étant prolongée par deux portions terminales, de préférence rectilignes, qui sont repliées vers l'intérieur du motif, en étant disposées de part et d'autre dudit bras, de préférence symétriquement par rapport audit bras, par exemple avec une forme de flèche ou d'ancre de navire.
- La paroi de protection est configurée pour focaliser les ondes radio incidentes vers une zone spécifique.
- Les ouvertures sont formées par perçage du corps.
- Le corps en forme de plaque est formé d'un seul tenant.

Selon un autre aspect, une armoire électrique comportant un logement délimité par une ou plusieurs parois de protection, le logement étant configuré pour recevoir au moins un appareil électrique capable de communiquer par radio, dans laquelle la ou les parois de protection sont telles que décrites ci-dessus.

L'invention sera mieux comprise et d'autres avantages de celle-ci apparaîtront plus clairement à la lumière de la description qui va suivre d'un mode de réalisation d'une telle paroi de protection donnée uniquement à titre d'exemple et faite en référence aux dessins annexés, dans lesquels :
[Fig 1] la figure 1 représente schématiquement une armoire électrique comportant une paroi de protection conforme à l'invention ;
[Fig 2] la figure 2 représente schématiquement une paroi de protection conforme à un mode de réalisation de l'invention ;
[Fig 3] la figure 3 représente schématiquement, sur son insert A), une ouverture formée dans la paroi de protection selon un mode de réalisation, et sur son insert B), représente une pluralités d'ouvertures formées dans la paroi de protection par répétition du motif géométrique de l'insert A).
[Fig 4] la figure 4 illustre schématiquement la périodicité géométrique des répétitions du motif de la figure 3 pour former une pluralité d'ouvertures dans la paroi de protection de la figure 2 ;
[Fig 5] la figure 5 représente une pluralités d'ouvertures formées dans la paroi de protection par répétition du motif géométrique selon un premier mode de réalisation alternatif ;
[Fig 6] la figure 6 représente une pluralités d'ouvertures formées dans la paroi de protection par répétition du motif géométrique selon un deuxième mode de réalisation alternatif.

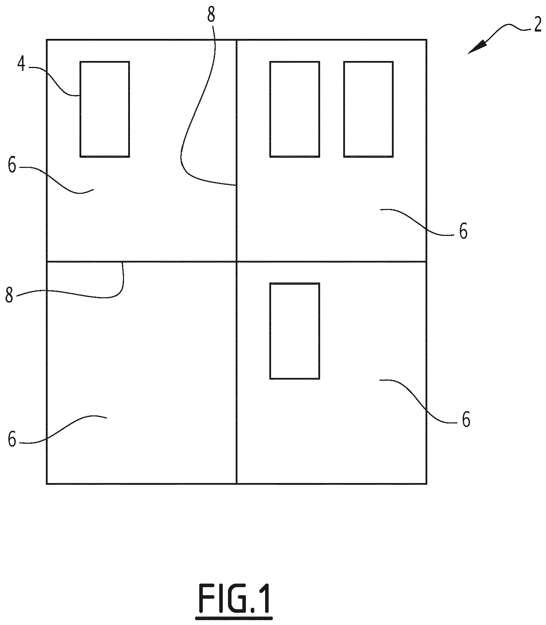

La figure 1 représente une armoire électrique 2 comportant une pluralité d'appareils électriques 4. Par exemple, l'armoire électrique 2 est utilisée dans une installation de distribution d'électricité.

Selon des modes de réalisation, les appareils électriques 4 peuvent être des appareils de commutation électrique, tels que des disjoncteurs ou des relais, mais aussi des appareils de mesure, des appareils de contrôle, des automates programmables industriels (PLC), et bien d'autres exemples encore.

De préférence, au moins une partie des appareils électriques 4 est configurée pour communiquer par émission et réception d'ondes radiofréquence.

Par exemple, ces appareils électriques comportent une interface de communication pourvue d'une antenne radio couplée à un circuit électronique d'émission/réception radio.

A titre d'exemple illustratif, ces appareils électriques peuvent communiquer selon un protocole de communication sans fil, par exemple pour former des liaisons radio de courte portée tels que Bluetooth, Zigbee (marques déposées) ou équivalent, mais aussi par un réseau sans fil, tel qu'un réseau Wi-Fi (marque déposée), ou par un réseau de télécommunications cellulaire.

Les appareils électriques 4 sont ici montés à l'intérieur de l'armoire électrique 2, par exemple en étant montés sur un ou plusieurs rails de fixation disposés à l'intérieur de l'armoire 2.

De préférence, l'armoire électrique 2 est partagée en une pluralité de logements 6 chaque logement étant au moins en partie délimité par des parois 8, aussi nommées parois de séparation ou parois de protection dans ce qui suit. On comprend que les parois 8 sont disposées à l'intérieur de l'armoire électrique 2. Les parois 8 peuvent avoir une forme de plaque. Il peut s'agir de plaques métalliques.

Dans certains modes de réalisation, les parois 8 sont au moins partiellement montées sur une armature de l'armoire 2. Les parois 8 peuvent être montées de façon amovible. Les parois 8 sont de préférence montées à l'intérieur de l'armoire 2, pour délimiter des logements intérieurs 6 en coopération avec d'autres parois 8 et/ou en coopération avec des parois extérieures de l'armoire 2. En variante, les parois 8 peuvent aussi être utilisées pour former des parois extérieures de l'armoire 2.

Par exemple chaque logement 6 accueille un ou plusieurs appareils électriques 4.

Ainsi, les appareils 4 peuvent être séparés les uns des autres (ou d'au moins une partie des autres appareils 4) par une ou plusieurs parois 8.

Les parois 8 comportent une pluralité d'ouverture traversantes qui permettent à l'air de circuler au travers de la paroi. Cela permet d'évacuer la chaleur dégagée par les appareils 4 lors de leur fonctionnement, afin d'éviter que cette chaleur ne s'accumule à l'intérieur des logements 6.

Les parois 8 sont également configurées pour permettre à des ondes radiofréquence d'être transmises au travers de la paroi 8, tout en assurant une protection mécanique suffisante.

Avantageusement, la paroi de protection 8 présente un niveau d'étanchéité supérieur ou égal à l'indice de protection IP2X défini par la norme EN 60529 et un niveau de résistance aux chocs supérieur ou égal à l'indice de protection IK02 défini par la norme EN 62262. En pratique, toutefois, ce niveau de résistance aux chocs est aussi inférieur ou égal à l'indice de protection IK05.

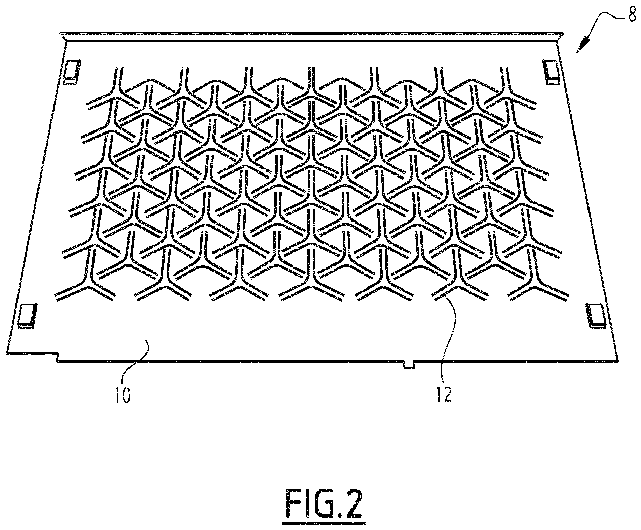

Comme illustré sur la figure 2, la paroi 8 comporte un corps 10 en forme de plaque et une pluralité d'ouvertures traversantes 12 formées dans le corps 10.

Les ouvertures 12 sont disposées sur la plaque suivant un motif géométrique obtenu par répétition périodique d'un même motif de base dans le plan de la paroi 8. Autrement dit, le motif de base 12 est répété avec une périodicité géométrique prédéfinie.

Notamment, les ouvertures sont formées par répétition périodique d'un même motif dans le plan du corps, le motif comprenant une ou plusieurs fentes ménagées dans le corps avec une forme géométrique spécifique et en ce que laquelle la pluralité d'ouvertures formée par répétition du motif présente une symétrie de rotation d'angle égale à 120° ou sensiblement égale à 120° (i.e., par exemple, égale à 120° à plus ou moins 10% près). Par exemple, chaque motif 12 comporte des fentes ménagées dans le corps. Avantageusement, les ouvertures 12 sont formées par perçage du corps 10.

En pratique, le corps 10 est formé d'un seul tenant. Par exemple, il s'agit d'une tôle métallique dans laquelle les fentes sont percées par découpage au moyen d'un outil de coupure, tel qu'une lame ou un poinçon ou un appareil de perçage par laser.

De préférence, la paroi 8 est réalisée en matière métallique, par exemple en acier.

Dans de nombreux modes de réalisation, dont plusieurs exemples seront décrits dans ce qui suit, les fentes présentent une largeur inférieure ou égale à 3mm et, de préférence, inférieure ou égale à 2,5mm et de préférence encore inférieure ou égale à 2,4mm.

Ainsi, cela permet d'obtenir une bonne étanchéité contre les corps étrangers, comme par exemple les corps présentant un diamètre supérieur à 2,5mm. Ainsi, par exemple, la paroi 8 peut présenter un indice de protection contre les corps étrangers de IP3X.

De façon optionnelle, le rapport entre, d'une part, la superficie cumulée des ouvertures et, d'autre part, la superficie d'une face de la plaque, pourrait être choisi inférieur ou égal à 0,4.

Les fentes permettent à l'air de circuler au travers de la plaque, à la manière d'ouïes de ventilation, ce qui permet de ventiler les logements 6 et d'évacuer au moins en partie la chaleur dégagée par les appareils 4 pendant leur fonctionnement, pour éviter que cette chaleur ne s'accumule dans les logements 6.

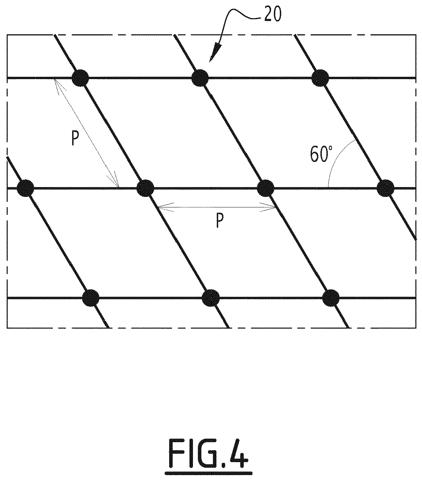

De préférence, comme illustré sur la figure 4, le motif de base 12 est répété de façon périodique pour former le motif complet de telle sorte que chaque motif de base 12 est placé sur un nœud 20 d'un réseau géométrique à deux dimensions qui s'inscrit dans le plan de la plaque 10.

Le réseau géométrique comprend une pluralité de mailles identiques qui présentent chacune une forme de quadrilatère dont les côtés ont une même longueur, notée P sur la figure 4. De préférence, les côtés de la maille ne sont pas perpendiculaires entre eux et, au contraire, sont inclinés avec un même angle.

Dans l'exemple illustré, chaque maille a une forme de parallélogramme dont l'angle aigu est égal à 60°, d'autres valeurs pouvant être choisies en variante.

La longueur P correspond ici à la périodicité géométrique de la répétition du motif de base.

Par exemple, le centre géométrique d'un motif de base est placé sur un nœud 20 du réseau, et le motif de base est répété, par translation, vers les autres nœuds 20 du réseau.

Les ouvertures formées par répétition du motif de base présentent une symétrie de rotation d'angle de 120°.

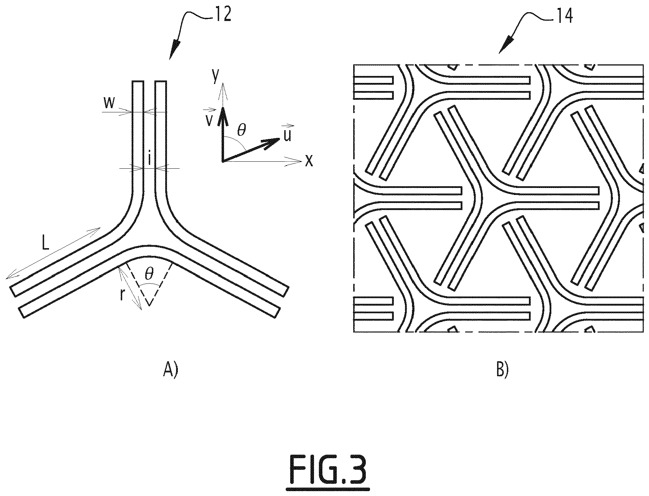

La figure 3 représente un exemple préféré d'un motif de base 12 (insert A) et d'une portion du motif global correspondant 14 lorsque le motif de base 12 est répété à l'échelle de la plaque 10.

Le motif 12 comporte trois bras équidistants s'étendant radialement depuis une zone centrale, les bras étant séparés deux à deux par un angle ici égal à 120°. L'angle entre le bras d'un motif 12 par rapport au bras d'un motif immédiatement voisin est alors égal à 60°.

Dans cet exemple, le motif comporte trois fentes séparées ménagées dans le corps 10 de la paroi 8.

Chaque fente présente une forme recourbée et définissant une partie de deux bras consécutifs, chacune des extrémités terminales de chaque fente étant alignée avec une extrémité terminale d'une autre fente.

Plus précisément, chaque fente comporte deux portions d'extrémité opposées, qui sont rectilignes ou essentiellement rectilignes, et qui sont connectées entre elles par une portion recourbée, qui est disposée dans la zone centrale du motif 12.

Sur la figure 3, on note « L » la longueur de chaque portion d'extrémité, « w » la largeur de chaque fente, « r » le rayon de courbure de la portion recourbée, « θ » l'angle complémentaire de l'angle entre les deux portions d'extrémités de chaque fente, et « i » l'espacement entre deux fentes voisines.

Chaque bras du motif comporte deux portions d'extrémités appartenant à deux fentes différentes. L'angle entre deux bras est ici égal à 120°.

De préférence, les trois fentes ont les mêmes caractéristiques de longueur L, de courbure r et de largeur w.

Le tableau ci-dessous (Table 1) donne des valeurs préférentielles pour la longueur « L » de chaque portion d'extrémité (équivalente à la longueur de chaque bras), la largeur « w » de chaque fente, le rayon de courbure « r » de chaque portion recourbée, l'angle complémentaire « θ » de l'angle entre les deux portions d'extrémités de chaque fente, et l'espacement « i » entre deux fentes voisines.

Les valeurs de longueur et de largeur sont exprimées en fonction de la longueur d'onde λ des ondes radio que l'on souhaite laisser passer (valeurs relatives λ), et aussi en millimètres pour le cas préféré d'ondes radio dans la bande de fréquences ISM à 2,4 GHz.

**[Table 1]**

| Paramètres | L | w | i | r | θ |
|---|---|---|---|---|---|
| Valeurs en [mm] | 24,6 | 2,4 | 2,4 | 11,87 | 60° |
| Valeurs relatives [λ] | 0,2 | 0,02 | 0,02 | 0,097 | 60° |

En variante, pour des ondes radio dans une bande de fréquences à 5 GHz, on peut choisir, pour ce même motif, les valeurs suivantes : L = 11,81mm, R = 5,7 mm, w = 1,15mm, la valeur de « i » pouvant rester inchangée, cet exemple étant donné à des fins d'illustration, d'autres valeurs pouvant être choisies en variante.

Ainsi, la pluralité d'ouvertures du motif global 14 formée par répétition du motif présente une symétrie de rotation d'angle de 120°.

L'invention permet d'obtenir une paroi de protection, et une armoire électrique correspondante, qui présentent une bonne étanchéité aux corps étrangers et une bonne résistance aux chocs tout en permettant le passage d'ondes radiofréquence.

Grâce aux valeurs choisies, les ouvertures sont suffisamment grandes pour permettre un passage suffisant de l'air et donc assurer une bonne ventilation, essentielle pour permettre l'évacuation de la chaleur dégagée par les appareils électriques.

Mais, ces ouvertures restent suffisamment petites pour ne pas nuire aux propriétés mécaniques de la paroi 8, notamment en ce qui concerne la résistance aux chocs, ou à la faculté d'empêcher des corps étrangers de pénétrer au travers de la paroi.

Le dimensionnement du motif et la façon dont ce motif est répété périodiquement dans le plan du corps 10 permet d'obtenir des bonnes propriétés de transmission des ondes radio fréquence au travers de la paroi 8, au moins pour la gamme de fréquences d'intérêt, et pour une plage suffisamment élevée d'angles d'incidence des ondes radio.

Enfin, le fait que le motif soit composé d'ouvertures traversantes, telles que des fentes, facilite la fabrication de la paroi 8. La paroi 8 peut être fabriqué à partir d'une plaque métallique d'un seul tenant, telle qu'une tôle métallique, par simple perçage, sans avoir besoin d'assembler de nombreux constituants.

En particulier, la paroi 8 permet la transmission des ondes radio pour des fréquences comprises dans un intervalle d'intérêt, par exemple dans la bande de fréquences ISM à 2,4 GHz (Bande industrielle, scientifique et médicale). Par exemple, cela correspond à l'intervalle de fréquences allant de 2,4 GHz à 2,483 GHz, ces valeurs étant inclues dans l'intervalle de fréquences.

Dans l'exemple illustré, la paroi 8 de la figure 2 permet de transmettre les ondes radio ayant une fréquence comprise dans la bande de fréquences ISM à 2,4 GHz avec une atténuation inférieure à 1 dB en valeur absolue, lorsque les ondes radio ont un angle d'incidence par rapport à la plaque allant jusqu'à 60°, et ce quel que soit l'angle de polarisation de ces ondes.

Ainsi, la paroi 8 agit comme une surface sélective en fréquence (« Frequency Selective Surface » en anglais), autorisant le passage d'au moins certaines ondes radio, en dépit du fait qu'elle soit construite en métal.

De façon encore plus préférentielle, la paroi 8 est configurée pour focaliser les ondes radio incidentes vers une zone spécifique.

D'autres modes de réalisation sont possibles. Notamment, la forme du motif de base (et donc la forme du motif global répétée sur la plaque) peuvent être modifiées, tout en permettant de bénéficier des mêmes avantages.

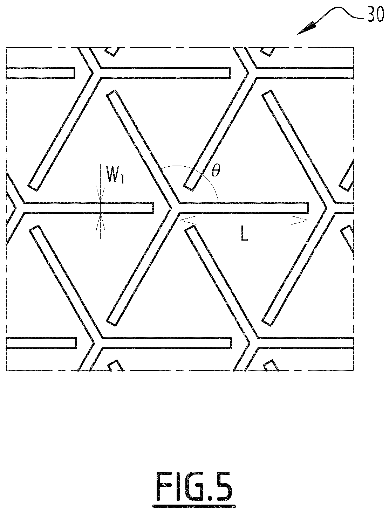

La figure 5 représente un exemple 30 d'un motif 12 selon un premier mode de réalisation alternatif.

Chaque motif de base comporte une fente à trois bras (ou, vu de façon alternative, trois fentes rectilignes jointes par leur extrémité distale).

Les bras ont une même longueur L et une même largeur W₁. Les bras s'étendent radialement depuis le centre du motif de base, et sont séparés deux à deux par un même angle θ.

Le tableau ci-dessous (Table 2) donne des valeurs préférentielles pour la longueur L, la largeur W₁ des fentes et l'angle θ séparant deux bras consécutifs d'un même motif de base.

Les valeurs de longueur et de largeur sont exprimées en fonction de la longueur d'onde λ des ondes radio que l'on souhaite laisser passer (valeurs relatives λ), et aussi en millimètres pour le cas préféré d'ondes radio dans la bande de fréquences ISM à 2,4 GHz.

**[Table 2]**

| Paramètres | Longueur L | Largeur W₁ | Angle θ |
|---|---|---|---|
| Valeurs en [mm] | 30,06 | 2,4 | 120° |
| Valeurs relatives [λ] | 0,245 | 0,02 | 120° |

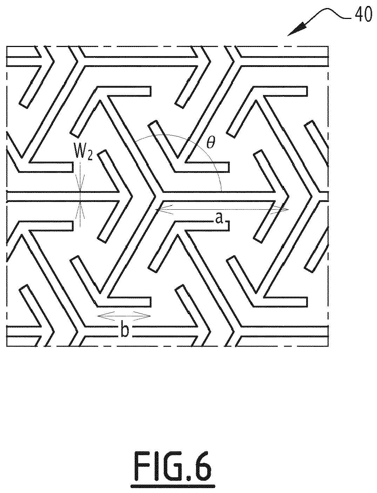

La figure 6 représente un exemple 40 d'un motif 12 selon un deuxième mode de réalisation alternatif.

Chaque motif de base comporte une fente à trois bras (ou, vu de façon alternative, trois fentes rectilignes jointes par leur extrémité distale), l'extrémité distale de chaque bras étant prolongée par deux portions terminales, de préférence rectilignes, qui sont repliées vers l'intérieur du motif, en étant disposées de part et d'autre dudit bras, de préférence symétriquement par rapport audit bras.

Par exemple, la combinaison de chaque bras avec les portions terminales correspondantes présente une forme évoquant une flèche ou une ancre de navire.

Les bras ont une même longueur L et une même largeur W1. Les bras s'étendent radialement depuis le centre du motif de base, et sont séparés deux à deux par un même angle θ.

Le tableau ci-dessous (Table 3) donne des valeurs préférentielles pour la longueur « a » de chaque bras, la longueur « b » de chaque portion terminale, la largeur W₂ de chaque fente et l'angle θ séparant deux bras consécutifs d'un même motif de base.

Les valeurs de longueur et de largeur sont exprimées en fonction de la longueur d'onde λ des ondes radio que l'on souhaite laisser passer (valeurs relatives λ), et aussi en millimètres pour le cas préféré d'ondes radio dans la bande de fréquences ISM à 2,4 GHz.

**[Table 3]**

| Paramètres | Longueur a | Longueur b | Largeur W₂ | Angle θ |
|---|---|---|---|---|
| Valeurs en [mm] | 16,2 | 10,4 | 1 | 120° |
| Valeurs relatives [λ] | 0,131 | 0,085 | 0,008 | 120° |

D'autres modes de réalisation sont possibles en variante.

Les modes de réalisation et les variantes envisagés ci-dessus peuvent être combinés entre eux pour donner naissance à de nouveaux modes de réalisation.

## Revendications

1. Paroi de protection métallique (8) pour une armoire électrique (2), la paroi de protection étant configurée pour délimiter au moins en partie un logement (6) dans l'armoire électrique, ledit logement étant destiné à recevoir un appareil électrique (4) capable de communiquer par radio,
**caractérisée en ce que** la paroi de protection comporte un corps (10) plat et une pluralité d'ouvertures (12) traversantes formées dans le corps,
et **en ce que** les ouvertures sont formées par répétition périodique d'un même motif dans le plan du corps, le motif comprenant une ou plusieurs fentes ménagées dans le corps avec une forme géométrique spécifique et **en ce que** laquelle la pluralité d'ouvertures formée par répétition du motif présente une symétrie de rotation d'angle égal ou sensiblement égal à 120°.

2. Paroi de protection selon la revendication 1, dans laquelle la paroi de protection (8) présente un niveau d'étanchéité supérieur ou égal à l'indice de protection IP2X défini par la norme EN 60529.

3. Paroi de protection selon la revendication 1 ou la revendication 2, dans laquelle la paroi de protection (8) présente un niveau de résistance aux chocs supérieur ou égal à l'indice de protection IK02 défini par la norme EN 62262.

4. Paroi de protection (8) selon l'une quelconque des revendications précédentes, dans laquelle la paroi de protection (8) permet la transmission des ondes radio pour les fréquences comprises dans la bande de fréquences ISM à 2,4 GHz.

5. Paroi de protection (8) selon l'une quelconque des revendications précédentes, dans laquelle le motif (12) comporte trois bras équidistants s'étendant radialement depuis une zone centrale, les bras étant séparés deux à deux par un angle de 120°.

6. Paroi de protection (8) selon la revendication 4, dans laquelle le motif comporte trois fentes ménagées dans le corps, chaque fente présentant une forme recourbée et définissant une partie de deux bras consécutifs, chacune des extrémités terminales de chaque fente étant alignée avec une extrémité terminale d'une autre fente.

7. Paroi de protection (8) selon la revendication 4, dans laquelle les trois bras équidistants du motif (30) s'étendant radialement depuis une zone centrale sont joints entre eux par leurs extrémités dans la zone centrale.

8. Paroi de protection (8) selon la revendication 4, dans laquelle le motif (40) comporte une fente à trois bras, l'extrémité distale de chaque bras étant prolongée par deux portions terminales, de préférence rectilignes, qui sont repliées vers l'intérieur du motif, en étant disposées de part et d'autre dudit bras, de préférence symétriquement par rapport audit bras, par exemple avec une forme de flèche ou d'ancre de navire.

9. Paroi de protection (8) selon l'une quelconque des revendications précédentes, dans laquelle la paroi de protection est configurée pour focaliser les ondes radio incidentes vers une zone spécifique.

10. Paroi de protection (8) selon l'une quelconque des revendications précédentes, dans laquelle les ouvertures sont formées par perçage du corps.

11. Paroi de protection (8) selon l'une quelconque des revendications précédentes, dans laquelle le corps en forme de plaque est formé d'un seul tenant.

12. Armoire électrique (2), comportant un logement (6) délimité par une ou plusieurs parois de protection (8), le logement étant configuré pour recevoir au moins un appareil électrique (4) capable de communiquer par radio, dans laquelle la ou les parois de protection sont conformes à l'une quelconque des revendications précédentes.
